# EUROPEAN PATENT APPLICATION

(11) **EP 1 258 915 A1**
(43) Date of publication of application: **20.11.2002**
(21) Application number: 01112140.7
(22) Date of filing: 17.05.2001
(51) Int. Cl.: H01L 21/66, H01L 21/00, G03F 7/20

(54) **Method of detecting defects on a semiconductor device in a processing tool and an arrangement therefore**

(71) Applicant: Infineon Technologies SC300 GmbH & Co. KG, 01099 Dresden (DE)
(72) Inventor: Seidel, Torsten, 01309 Dresden (DE); Otto, Ralf, 01723 Kesselsdorf (DE); Schedel, Thorsten, 01129 Dresden (DE); Marx, Eckhard, 01471 Radeburg (DE); Hraschan, Günther, 01109 Dresden (DE)
(74) Representative: Epping Hermann & Fischer

(57) **Abstract**

A processing tool (1) for manufacturing semiconductor devices (2), e.g. a lithography cluster, comprises a device transfer area (8) with an optical sensor (10), preferably a CCD-camera, and an illumination system (11) mounted within, such that a semiconductor device (2) being transferred to or from one of its processing chambers (1a, 1b, 1c) can be scanned during its movement at low resolution. The scanning is performed twice, prior and after processing in at least one the processing chambers (1a, 1b, 1c) of the processing tool (1). Both images are compared and optionally subtracted from each other. Defects imposed to the semiconductor device due to contaminating particles only during the present processes with sizes larger than 10 µm are visible on the subtracted image, while defects imposed earlier are diminished as well as structures formed from e.g. a mask pattern below 10 µm. Pattern recognition allows an efficient classification of the defects being just detected in a processing tool (1). Thus, semiconductor device yield and metrology capacity are advantageously increased.

## Description

Method of detecting defects on a semiconductor device in a processing tool and an arrangement therefore

The present invention relates to a method of detecting defects on a semiconductor device in a processing tool, a device transfer area, a optical sensor and an illumination system for illuminating an area monitored by said optical sensor.

In semiconductor device manufacturing - particularly semiconductor wafers - a sequence of processing steps is performed to build structures like integrated circuits on their surfaces. Many of these processing steps are followed by metrology steps in order to check, whether the process just carried out fulfills the corresponding device specification requirements.

In the case of semiconductor wafers, e.g., four measurement operations are often needed to control the quality of the lithographic process including the full cleantrack, i.e. coating and developing etc. These operations typically include an overlay measurement, a critical dimension measurement, a flood light inspection and an additional microscope inspection. Semiconductor devices failing these examinations are commonly sent into rework.

Although for such device quality checks high resolutions are often not necessary in order to detect defects such as focus spots etc., that have just been imposed to said devices, elaborate metrology tools available in the fab inevitably have to be used to carry out the required inspections or measurements. Thus, in many instances expensive metrology tools are used to do simple checks.

Moreover, since large distances in the cleanroom area have to be travelled for transferring a semiconductor device from a process tool to a metrology tool, time is lost, and the information feedback for solving problems with the processing tool is disadvantageously slow.

It is therefore a primary objective of the present invention to reduce the efforts spent in measurement operations after a process for manufacturing semiconductor devices, thereby decreasing the costs spent in metrology tools, and to reduce the amount of rework of semiconductor devices thereby optimising the processing tool utilization time.

The objective is solved by a method of detecting defects on a semiconductor device in a processing tool, which comprises a device transfer area, a optical sensor and an illumination system for illuminating a space monitored by said optical sensor, comprising the steps of providing said semiconductor device to said device transfer area, recording a first image of said semiconductor device using said optical sensor, transferring said semiconductor device to said processing tool, performing a process step on said semiconductor device, transferring said semiconductor device back to said device transfer area, recording a second image of said semiconductor device using said optical sensor, comparing the first and the second image, issuing a signal in response to said comparison, and is also solved by an arrangement for detecting defects in at least one of said processing tools.

According to the present invention an in-situ measurement of semiconductor devices in a processing tool is provided. A prerequisite of the present invention is, that the process tool is part of an arrangement including a load port, a device transfer area typically being operated by a robot having an arm for transporting the devices, and an active processing unit, i.e. the processing tool in a narrower sense.

The method and arrangement according to the present invention are aiming at monitoring and controlling low resolution device structures, which therefore do not require a long measurement time, a high precision alignment, or a high resolution sensor. This is performed by means of an optical sensor, which can be a CCD-camera being able to record pictures of the devices with a resolution of a few to hundreds of microns.

In this document the area of the processing tool inside a load port and outside the processing chamber, i.e. the active processing unit of a processing tool, is considered to be the device transfer area.

The optical sensor and the illumination system are integrated within the process tool periphery, i.e. the device transfer area. Thus, the present invention is suited to cleanroom area processing tools having a loadport, where device carriers are laid upon in order to be unloaded from their device load by means of robot arms. Those processing tools commonly provide a mini-environment within, and all device handling is arranged such as to minimise contamination with particles due to mechanical friction and abrasion.

Device handling and transfer is often provided by robots or similar mechanics comprising robot arms having chuck-like properties to hold a semiconductor device, e.g. a semiconductor wafer.

The present invention utilises two characteristics of the device transfer area: Typically, semiconductor devices are transferred to the processing chambers and removed from the processing chambers along similar paths. Additionally, transfer velocities are sufficiently slow, such that low resolution images can be taken from the semiconductor devices while being transferred.

A further advantage is, that a common device transfer area of semiconductor manufacturing equipment has comparatively large amounts of space left to receive typical optical sensors.

The central issue of the present invention is, that a low resolution picture of the semiconductor device is taken before and after one or more process steps. Both pictures are then compared, the differences thereby showing large scale effects that have been applied to the semiconductor device.

A main contributor to defects detected conventionally using metrology tools are focus spots. These are originating from particles adhering to the backside of the semiconductor device, particularly semiconductor wafers. A small elevation of the device frontside develops, which in the case of exposing a semiconductor wafer results in a defocus with respect to the optical system of the exposure tool. Although the elevation is small - having roughly the size of the particle diameter - the lateral extent can become up to 1 × 1 cm or even larger. Inside such an area pattern structures hardly develop in the resist. As a result the corresponding integrated circuit is damaged. Those large scale defects can easily be seen by eye e.g. by means of a floodlight inspection.

Using the optical sensor and the method according to the present invention the subtracted images in low resolution reveal nearly constant differences between the pre-process and the post-process device image with the exception of large scale defect contributions due to contaminating particles such as focus spots on semiconductor wafers imposed during the prsent process. Contrarily large scale features that have been structured on the device surface priorily are evident on both pictures before subtraction - pre-process and post-process - and are therefore not evident on the subtracted image. Thus, the present invention advantageously allows a defect control of precisely the present process or sequence of process steps.

Commonly, structures imprinted onto the semiconductor device due to the present process, e.g. exposure with a mask pattern, generally have a smaller structure size, and are therefore not resolved with the optical sensor according to the present invention. Thus, the structures will not be detected as differences in the compared or subtracted images.

Most preferably, optical optical sensors having a resolution of 50 - 100 µm are used according to the present invention, but also more expensive cameras with resolutions down to 10 - 20 µm can be applied according to the actual state camera technology.

According to the method of the present invention a signal is generated in response to the comparison of the first and second image. Preferably, the signal is issued in response to a defect pattern recognised in a subtracted image. In an aspect of the present invention further processing of semiconductor devices is considered to be stopped, if a threshold value of e.g. defect numbers or size is exceeded. Also, the signal may comprise information for the work-in-progress system about the semiconductor device identification number affected and/or the location of the defect on said device.

In a further aspect the method is considered to comprise a pattern recognition property, which identifies patterns in the subtracted image after which it compares the identified pattern with at least one reference pattern, preferably with a library of reference patterns. In a further aspect each of the reference patterns from the library is considered to represent different kinds of defects. According to still a further aspect examples of patterns are a particle on a device backside causing a focus spot as described above, a particle on a device frontside causing distortions during the resist spin on (comets), and particles on a device frontside causing resist lift-off when being barried below the resist.

Another advantageous aspect of the present invention is the property of recording the images using the optical sensor during the semiconductor device movement while it is transferred, the sensor being constructed as a scanning system. Thereby, the optical sensor may be mounted above the semiconductor device transfer path and the movement for performing the scanning is provided by the robot arm transfer. An on-the-fly inspection of 5 seconds is possible, then. A corresponding backside inspection of the semiconductor wafer can be enabled by an optical sensor mounted below the device transfer path. A simultaneous inspection is either possible by providing two sensors according to the present invention - one mounted above and the other mounted below said tranfer path - or by supplying a moving means or a mirror to the arrangement.

A mechanical movement of optical parts of the optical sensor provides a corresponding depth of focus, which is necessary, if the vertical transfer path height to and from the processing chamber deviate from each other. In the case of a lithography cluster having an in- and output slot for providing semiconductor wafers from a robot area to the device transfer area these deviations typically amount to ,e.g., 4 cm, with which the corresponding vertical movement of the optical sensor is at least to be provided.

According to the present invention the device transfer area may also serve for transferring semiconductor devices between a sequence of processing tools. In the case of the lithography cluster coating, exposure and developing are performed sequentially and the images are taken before the coating step and after the developing step.

According to the present invention a method of detection defects on a robot arm without carrying a semiconductor device is also provided. Comparing the pictures of the robot arm before carrying out one or more transfer actions and after it, newly adhering particles sticked to the robot arm surface can easily be detected.

According to the present invention using the optical sensor and the pattern recognition software a large scale device identification number printed on the device surface can also be detected.

Further advantages and aspects are evident from the dependent claims. The invention will be better understood by reference to the following description of embodiments of the invention taken in conjunction with the encompanying drawings, wherein
- figure 1: shows a front view (a), and a side view (b) of an arrangement according to the present invention in a lithography cluster,

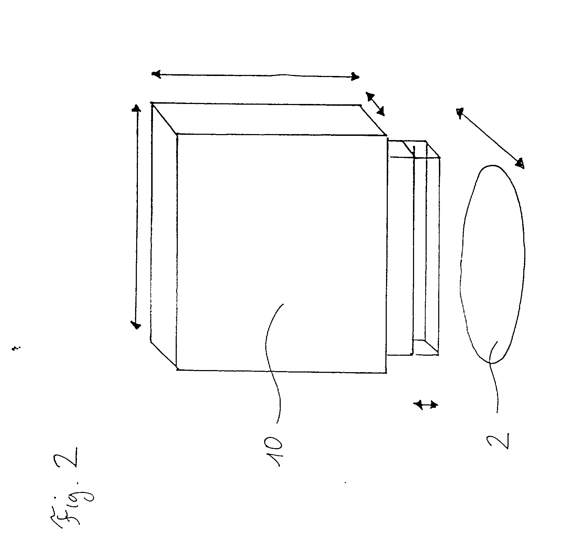

- figure 2: schematically shows a optical sensor with typical dimensions according to an embodiment of the present invention,
- figure 3: shows a flow chart of a lithography process of semiconductor wafers with an in-situ defect control according to the method of the present invention.

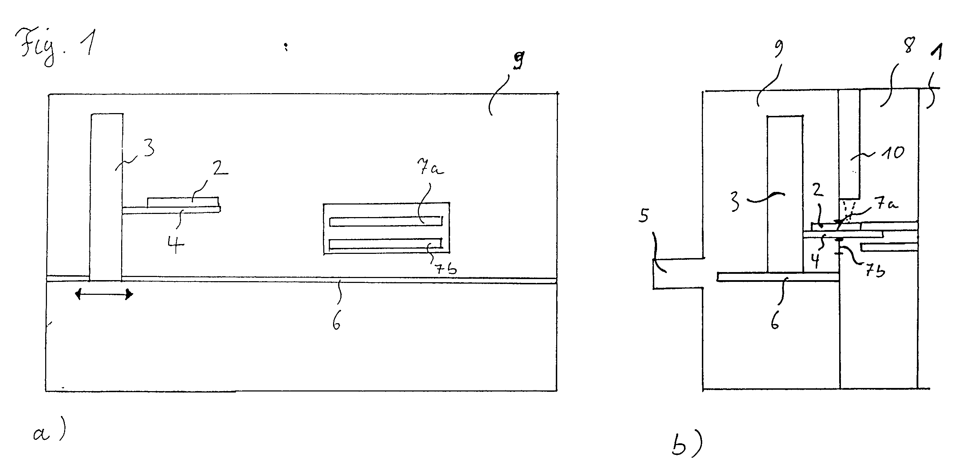

The arrangement in a lithography cluster as an embodiment of the present invention is shown in figure 1a. In this front view of the cluster a robot 3 carrying a semiconductor wafer 2 on its robot arm 4 is shown to move along a linear axis 6 for robot movement. The robot 3 transfers said semiconductor wafer 2 from a load port 5 to an input slot 7a. The input slot 7a is the input connection between the robot handling area 9 and the device transfer area 8. As shown in figure 1b the robot 3 transfers the semiconductor device 2 through the input slot 7a into the device transfer area 8 for being further transported to the coating processing tool 1a.

A optical sensor 10 is mounted above the input slot 7a, such that the semiconductor wafer 2 is scanned while being transferred through input slot 7a. The duration of the scan is about 5 seconds. The optical system of the optical sensor 10 is provided with a motor such as to provide a focus depth of 4 cm, which is the difference in height between the input slot 7a and the output slot 7b, through which the semiconductor wafers are transferred after processing through the coat process 1a the exposure 1b and the develop process 1c among further steps.

In order to scan, e.g., 300 mm wafers the optical sensor has a width of 32 cm - the same as the input and output slot width - with a height of 36 cm and a depth of 6 cm. A control unit provides a synchronisation between the wafer transfer and the inspection during the scan. A one-dimensional image is taken while the orthogonal movement provides the scan in the second dimension.

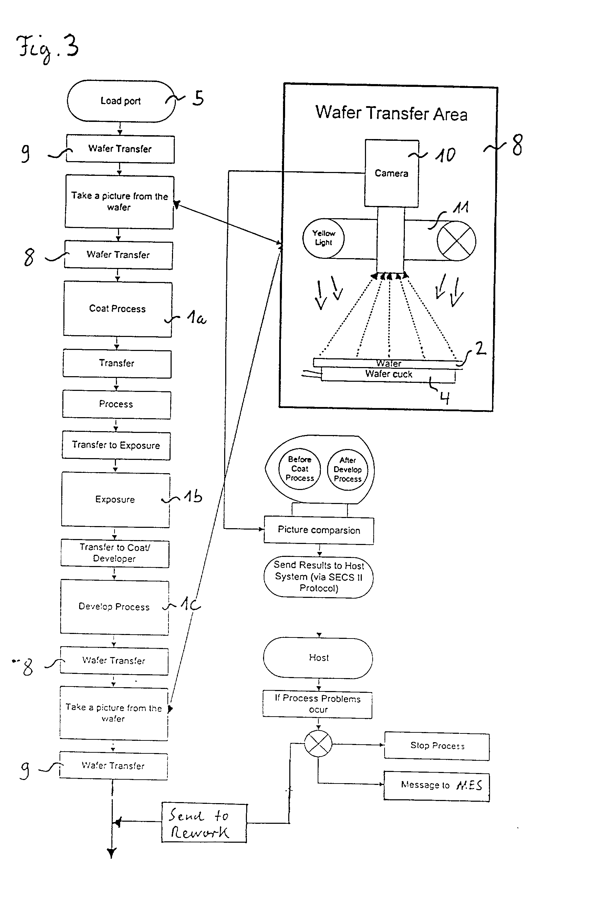

The method according to the present invention is illustrated in a flow chart shown in figure 3. A semiconductor wafer is unloaded from a device carrier deposited on a load port 5 of a lithography cluster. By means of the robot 3 the semiconductor device is transferred through the robot handling area 9 and scanned for recording an image by the optical sensor 10 when being transferred through the input slot 7a. After that the automatic handling system transfers the semiconductor wafer 2 through the device transfer area 8 to a coater 1a. After being further transferred and processed the wafer is exposed with a mask pattern in an exposure tool 1b and than transferred to the developer 1c.

Eventually, the semiconductor wafer 2 is transferred back to the output slot 7b. While sliding through it the second image is taken with a CCD-camera 10 as an optical sensor. During recording the images the semiconductor wafer 2 is illuminated annularly in yellow light by an illumination system 11. Both pictures - before the coat process and after the develop process - are then compared and the results sent, e.g., via a SECS II connection to the lithography cluster host system. There, the pattern recognition is performed and particle defects are detected. These are classified, and if a threshold value of particle sizes or numbers is exceeded, a signal directed to the host is issued for stopping the current process and marking the current product to be sent into rework.

### List of numerals

- 1: process tool, lithography tool
- 2: semiconductor device, wafer
- 3: robot
- 4: robot arm
- 5: loadport
- 6: linear axis for robot movement
- 7a: input slot
- 7b: output slot
- 8: device transfer area
- 9: robot handling area
- 10: optical sensor
- 11: illumination system

## Claims

1. Method of detecting defects on a semiconductor device (2) in a processing tool (1), which comprises a device transfer area (8), an optical sensor (10) and an illumination system (11) for illuminating an area monitored by said optical sensor (10), comprising the steps of
- providing said semiconductor device (2) to said device transfer area (8),
- recording a first image of said semiconductor device (2) using said optical sensor (10),
- transferring said semiconductor device (2) to said processing tool (1),
- performing a process step on said semiconductor device (2),
- transferring said semiconductor device (2) back to said device transfer area (8),
- recording a second image of said semiconductor device (2) using said optical sensor (10),
- comparing the first and the second image,
- issuing a signal in response to said comparison.

2. Method according to claim 1,
**characterized in that**
the comparison is performed by
- subtracting one of the images from the other,
- identifying patterns in the substracted image,
- comparing the identified pattern with at least one reference pattern.

3. Method according to claim 2,
**characterized in that**
said at least one reference pattern is provided representing defect on a semiconductor device (2).

4. Method according to claim 3,
**characterized in that**
said defect is at least one of
- a particle on a device backside causing a focus spot,
- a particle on a device frontside causing distortions during resist spin on,
- a particle on a device frontside causing resist lift-off.

5. Method according to anyone of claims 1 to 4,
**characterized in that**
said first and second image is recorded by scanning said semiconductor device (2) during a movement of said semiconductor device (2) across the device transfer area (8).

6. Method according to anyone of claims 1 to 5,
**characterized in that**
the processing of the inspected semiconductor device (2) is stopped in response to said signal.

7. Method of detecting defects on a robot arm (4) in a processing tool (1), which comprises a device transfer area (8), an optical sensor (10) and an illumination system (11), whereby said robot arm (4) is provided for transferring a semiconductor device (2) to said device transfer area (8), comprising the steps of:
- moving said robot arm (4) to said device transfer area (8) without being loaded with a semiconductor device (2),
- recording a first image of said robot arm (2) in said device transfer area (8),
- transferring a number of devices (2) to an from device transfer area (8) using said robot arm (4),
- moving said robot arm (4) to said device transfer area (8) without being loaded with a semiconductor device (2),
- recording a second image of said robot arm (4) in said device transfer area (8),
- comparing said first and second image,
- issuing a signal in response to said comparison.

8. Method of detecting a device identification number structured on the surface of a semiconductor device (2) in a processing tool (1), which comprises a device transfer area (8), an optical sensor (10) and an illumination system (11), comprising the steps of
- providing said semiconductor device (2) to said device transfer area (8),
- recording an image of said semiconductor device (2),
- identifying said identification number by means of a pattern recognition algorithm,
- issuing a signal in response to said identification.

9. Arrangement for detecting defects in a processing tool (1), comprising:
- a loadport (5) for loading or unloading at least one semiconductor device (2) to said processing tool (1),
- a device transfer area (8),
- at least one processing chamber (1a, 1b, 1c),
- a robot arm (4) for maintening the transfer of semiconductor devices (2) between said loadport (5) and said at least one processing chamber (1a,1b,1c),
- a optical sensor (10) with an illumination system (11), which is mounted within said device transfer area (8), such that an image of at least one of said semiconductor devices (2) being held by said robot arm (4) in said device transfer area (8) can be recorded by said optical sensor (10),
- a control unit being connected to said optical sensor (10) for recording the images taken with said optical sensor (10), and for performing a comparison of said images.

10. Arrangement according to claim 9,
**characterized in that**
said optical sensor (10) is a sensor for performing a macro-defect inspection.

11. Arrangement according to claim 10,
**characterized in that**
said optical sensor (10) has a minimum resolvable structure width of more than 10 µm and of less than 100 µm.

12. Arrangement according to anyone of claims 9 to 11,
**characterized in that**
- said optical sensor (10) is a scanner recording images in columns from said semiconductor device (2) during a movement of said device (2) due to said robot arm (4),
- said control unit is connected to a motor moving said robot arm (4) for obtaining the semiconductor device (2) position during a movement,
- said control unit comprises a processing unit for building an image from said image columns and said semiconductor device (2) positions.

13. Arrangement according to anyone of claims 9 to 12,
**characterized in that**
said optical sensor (10) comprises a focussing means, which is connected to said control unit, for focussing said optical sensor (10) to a distance according to the height of the transfer path of said semiconductor device.
